# EUROPEAN PATENT APPLICATION

(11) **EP 4 429 420 A1**
(43) Date of publication of application: **11.09.2024**
(21) Application number: 23160902.5
(22) Date of filing: 09.03.2023
(51) Int. Cl.: H05K 5/02

(54) **A HOUSING FOR AN ELECTRONIC ELEMENT**

(71) Applicant: Harman Professional Denmark ApS, 8200 Aarhus N (DK)
(72) Inventor: Rasmussen, Niels Joergen, 8250 Egaa (DK)
(74) Representative: Kraus & Lederer PartGmbB

(57) **Abstract**

The present disclosure provides a housing for an electronic element. The housing comprises a wall separating an exterior space outside the housing and an inner space inside the housing and comprises an opening between the exterior space and the inner space, and an elastically deformable sealing valve configured to be removably inserted in the opening to close the opening. The sealing valve comprises an insert part for insertion into the opening and a support part for arrangement against the outer surface of the wall. The sealing valve forms a path from an inlet opening to an outlet opening, where the path extends in a longitudinal direction, and where the inlet opening is formed in the support part and the outlet opening is formed in the insert part. The support part comprises a first surface part for arrangement against the outer surface of the wall, and the insert part comprises a second surface part for arrangement against the inner surface of the wall. The first and second surfaces parts form a groove extending circumferentially along an outer surface of the sealing valve transverse to the longitudinal direction. An edge portion of the wall being is in the groove, when the sealing valve is inserting in the opening.

## Description

### FIELD OF THE DISCLOSURE

The present disclosure relates to a housing for an electronic element, such as a lighting product, a loudspeaker, an amplifier, a sound mixer, or another electronic element, in particular to a housing with a valve.

### BACKGROUND OF THE DISCLOSURE

In entertainment and architectural lighting and music industry, light fixtures, loudspeakers, and other electronic elements are often used outdoor with the risk of rain showers. Therefore, the product should either be placed safely under a roof, or it should be ingress protected.

### SUMMARY

It is an object of embodiments of the disclosure to provide an improved housing for an electronic element.

It is a further object of embodiment of the disclosure to provide a housing with a valve.

It is a further object of embodiment of the disclosure to provide a housing with a valve allowing inspection of an inner space of the housing.

In a first aspect, the disclosure provides a housing for an electronic element, the housing comprising:
- a wall separating an exterior space outside the housing and an inner space inside the housing, the wall forming an outer surface towards the exterior space and an opposite inner surface towards the inner space and comprising an opening between the exterior space and the inner space, and
- an elastically deformable sealing valve configured to be removably inserted in the opening to close the opening,

wherein the sealing valve comprises an insert part for insertion into the opening and a support part for arrangement against the outer surface of the wall, the sealing valve forming a path from an inlet opening to an outlet opening, the path extending in a longitudinal direction, the inlet opening being formed in the support part and the outlet opening being formed in the insert part, and
wherein the support part comprises a first surface part for arrangement against the outer surface of the wall, and wherein the insert part comprises a second surface part for arrangement against the inner surface of the wall, the first and second surface parts forming a groove extending circumferentially along an outer surface of the sealing valve transverse to the longitudinal direction, an edge portion of the wall being arranged in the groove, when the sealing valve is inserting in the opening.

The sealing valve may seal the opening in the wall when inserted in the opening. The sealing valve may engage the wall, when an edge portion of the wall is inserted in the groove formed along the outer surface of the sealing valve. The sealing valve is configured for removable insertion in the opening. The sealing valve may provide the ability to clean the inner space without separating parts of the housing to open it and may further provide the ability of inspection of the inner space without opening the housing. This may be particularly relevant for a housing to be used in products with an IP rating below 66.

To improve the sealing capability of the sealing valve, a cross-sectional shape of the groove may substantially match a shape of the opening. The opening and the cross-sectional shape of the groove may be substantially circular.

The wall may be substantially plane or substantially convex towards the exterior space. This may reduce the risk of water being trapped around the opening, and thereby reduce the risk of water ingress through the sealing valve.

The support part may have a height being defined as a dimension in the longitudinal direction, where the height may be lower along an outer circumference of the support part than at the inlet opening. This may reduce the risk of water at the support part, as water may flow away from the inlet opening towards the circumference. The height of the support part may taper down from the inlet opening towards the outer circumference to further reduce the risk water ingress.

An upper surface of the support part may form a substantially convex surface facing away from the wall. This may increase the possibility of leading water away from the inlet opening and may further provide the ability of ramping of water droplets.

The height of the support part along the outer circumference may be less than 2 mm. By providing the support part with a reduced height along the outer circumference, the risk of unintended removal of the sealing valve during handling of the housing may be reduced.

In one embodiment, the height of the support part along the outer circumference may be 1/5 or less than a distance between the first and second surface parts. The distance between the first and the second surface parts corresponds to the size of the groove in the longitudinal direction. This distance may further correspond to the wall thickness to improve the sealing capability of the sealing valve.

An outer cross-sectional size of the insert part transverse to the longitudinal direction may be larger at the second surface part than at an opposite distal end of the insert part. By decreasing the size at the distal end, insertion of the sealing valve into the opening maybe facilitated.

A size of the inlet opening transverse to the longitudinal direction may be 1 mm or less, such as 0.5 mm or less. This may prevent or at least considerably reduce the risk of water ingress through the inlet opening, while still providing a path from the inlet opening to the outlet opening.

The inlet opening may be expandable from a closed configuration to an open configuration by deformation of the support part. This may as an example be achieved by forming the inlet opening by a needle or a similar tool, e.g., substantially without removal of material. When the support part is un-affected the inlet opening may be substantially sealed, and when applying a pressure at the support part the inlet opening may be opened.

A size of the outlet opening transverse to the longitudinal direction; i.e. the cross-sectional size, may be in the range of 1.0-3.0 mm. This may reduce the pressure loss along the path.

A cross-sectional size of the path may be substantially uniform along the longitudinal direction of the insert part. A substantially uniform size of the path may reduce the pressure loss along the path. To provide a transition from the inlet opening to the outlet opening, a cross-sectional size of the path may taper down along the longitudinal direction of the support part.

To reduce the risk of the sealing valve being pushed fully through the opening in the wall, a cross-sectional size of the support part along the first surface past may be in the range of 1.5-2.5 times a cross-sectional size of the insert part at the distal end. The smaller cross-sectional size of the insert part may facilitate insertion of the sealing valve into the opening.

To facilitate insertion of the sealing valve into the opening, a size of the insert part in the longitudinal direction may be at least twice a size of the support part in the longitudinal direction. A smaller size of the support part in the longitudinal direction (the height of the support part) may further reduce the risk of unintentional removal of the sealing valve during handling and/or use of the housing.

The sealing valve may be formed by a material being hydrophobic. This may reduce the risk of water ingress to the inner space via the path. As an example, the material may be a polymer-based material, such as thermoplastic polyurethane (TPU) or Silicone.

The housing is for an electronic element which as an example may be a lighting product, a loudspeaker, an amplifier, a sound mixer, a motor, or another electronic element. In one embodiment the housing may form part of a light fixture, such as a moving head light fixture. The moving head light fixture may comprise e.g., a head, a yoke, and a base, which may each comprise a housing for an electronic element. As an example, the housing of the head may comprise at least a light source, the housing of the yoke may comprise at least one motor, and the housing of the base may comprise as least a controller for controlling e.g., movement of the head, the light fixture, etc.

In a second aspect, the disclosure provides a method of manufacturing a sealing valve for a housing according to any of the first aspect, the method comprising the steps of:
- providing a mould and an ejector punch,
- injecting a valve material into the mould to form the sealing valve,
- setting the sealing valve, and
- removing the sealing valve from the mould by use of the ejector punch.

It should be understood, that a skilled person would readily recognise that any feature described in combination with the first aspect of the disclosure could also be combined with the second aspect of the disclosure, and vice versa.

The method according to the second aspect of the disclosure is very suitable for manufacturing a sealing valve according to the first aspect of the disclosure. The remarks set forth above in relation to the housing and the sealing valve are therefore equally applicable in relation to the method.

The ejector punch may comprise a needle element, and the step of removing the sealing valve from the mould may comprise a step of providing the inlet opening by penetrating the support part by the needle element. The inlet opening be provided substantially without removing material, or at least provided by removing only a limited amount of valve material.

### BRIEF DESCRIPTION OF THE DRAWINGS

Embodiments of the disclosure will now be further described with reference to the drawings, in which:
Fig. 1 illustrates different views of a light fixture;
Fig. 2 illustrates different views of a sealing valve;
Fig. 3 illustrates a cross-sectional view of a light fixture comprising a housing with three sealing valves;
Fig. 4 illustrates a cross-sectional view of a light fixture being visually inspected;
Fig. 5 illustrates a cross-sectional view of a light fixture being inspected by use of a camera; and
Fig. 6 illustrates a cross-sectional view of a light fixture being cleaned.

### DESCRIPTION OF EMBODIMENTS

It should be understood that the detailed description and specific examples, while indicating embodiments of the disclosure, are given by way of illustration only, since various changes and modifications within the scope of the disclosure will become apparent to those skilled in the art from this detailed description.

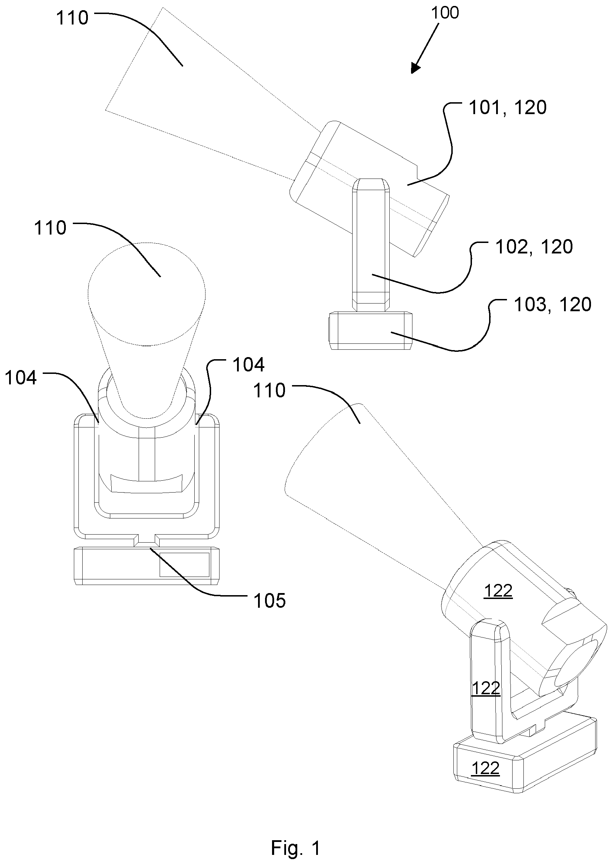

Fig. 1 illustrates different views of a light fixture 100 in the form of a moving head light fixture. The light fixture 100 comprises a head 101, a yoke 102, and a base 103. Two first joints 104 are arranged between the head 101 and the yoke 102, and a second joint 105 is arranged between the between base 103 and the yoke 102 to provide a head 101 being rotatably connected to a yoke 102, and a yoke 102 being rotatably connected to a base 103.

A light beam 110 schematically illustrates the light fixture 100, when turned on. By use of the motors, the position of the light beam 110 can be changed.

Each of the head 101, the yoke 102, and the base 103 comprises a housing 120 for an electronic element which as an example may be a light source, a motor, or another electronic element. The housing 120 comprises at least one wall 122.

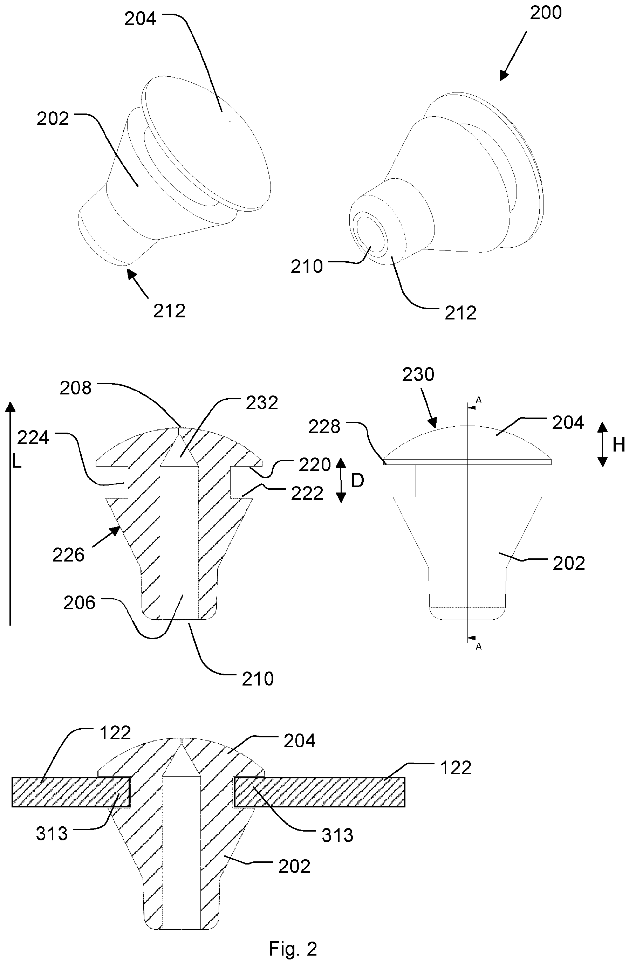

Fig. 2 illustrates different views of a sealing valve 200, where the lower left view is a cross-sectional view along section A-A in the lower right view. The sealing valve 200 is configured to be inserted into an opening 310 in the wall 122 of the housing 120.

The sealing valve 200 may be made in one piece and may as an example be made of a polymer-based material, such as thermoplastic polyurethane (TPU) or Silicone. To lower the risk of water ingress through the sealing valve 200, the valve material may be hydrophobic. In an alternative embodiment the sealing valve 200 may be made of two or more parts, where only some of the parts may be elastically deformable.

The sealing valve 200 comprises an insert part 202 for insertion into the opening 310 and a support part 204 for arrangement against the outer surface 312 of the wall 122. The sealing valve 200 forming a path 206 from an inlet opening 208 to an outlet opening 210. The path 206 extends in a longitudinal direction of the sealing valve 200, where the longitudinal direction indicated by the arrow L is defined as the direction along the largest dimension of the sealing valve. The inlet opening 208 is formed in the support part 204 and the outlet opening 210 is formed in the insert part 202. In the illustrated embodiment, the outlet opening 210 is provided at the distal end 212 of the insert part 202. The path 206 may be provided to allow air to pass from the exterior space 306 to the inner space 308 and allow air to pass in the opposite direction.

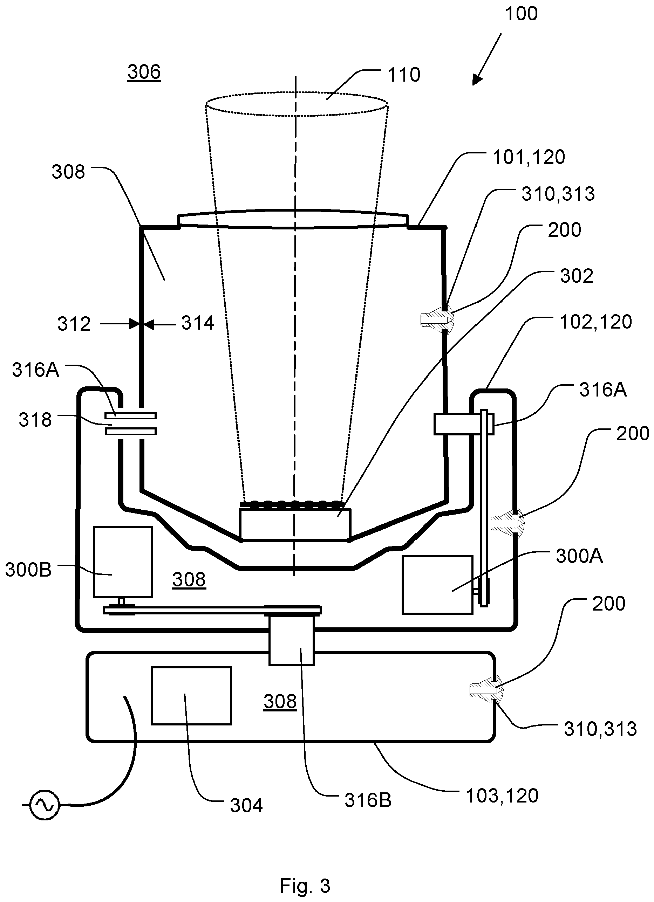

The support part 204 comprises a first surface part 220 for arrangement against the outer surface 312 of the wall 122, when the sealing valve 200 is inserted in the opening 310. The insert part 202 comprises a second surface part 222 for arrangement against the inner surface 314 of the wall 112, when the sealing valve 200 is inserted in the opening 310. The first and second surface parts 220, 222 form a groove 224 extending circumferentially along an outer surface 226 of the sealing valve 200 transverse to the longitudinal direction. When the sealing valve 200 is inserting in the opening 310, an edge portion 313 (see also Fig. 3) of the wall 120 is arranged in the groove 224.

The support part 204 may have a height H being defined as a dimension of the support part in the longitudinal direction, where the height may be lower along an outer circumference 228 of the support part than at the inlet opening 208. The height along the outer circumference 228 may be less than 2 mm, such as less than 1 mm. By providing the support part 204 with a low height along the outer circumference 228, the risk of unintentional removal of the sealing valve 200, e.g., when packing and/or unpacking the housing 120 with the sealing valve 200, may be considerably reduced. The height along the outer circumference may be 1/5 or even less than a distance D between the first and second surface parts 220, 222.

The height H of the support part 204 along the longitudinal direction may taper down from the inlet opening 208 towards the outer circumference 228. By tapering down the height of the support part 204, water falling on or flowing towards the support part 204 may be ramped off the support part 204 to limit the risk of water ingress into the housing 120 via the path 206. To increase the possibility of leading of water and/or the ramping off effect, the upper surface 230 of the support part 204 may form a substantially convex surface facing away from the wall 122.

The sealing valve 200 may be substantially rotational symmetrical along the longitudinal direction L to facilitate insertion of the sealing valve 200 into the opening 310. This may additionally facilitate removal of the sealing valve 20 from the opening 310. In the illustrated embodiment, the sealing valve 200 is substantially circular at cross-sections along the longitudinal direction L, where the outer diameter of the sealing valve 200 varies along the longitudinal direction L.

An outer cross-sectional size of the insert part 202 transverse to the longitudinal direction L may be larger at the second surface part 222 than at the opposite distal end 212 of the insert part 202. In the illustrated embodiment, the outer cross-sectional size corresponds to the outer diameter, as the sealing valve 200 is substantially circular in cross-sections along the longitudinal direction. By providing the insert part 24 with a diameter being smaller at the distal end 212 than at the second surface 222, insertion of the sealing valve 200 into the opening 310 may be facilitated.

A size of the inlet opening 208 transverse to the longitudinal direction may be 1 mm or less, such as 0.5 mm or less. By providing the path 206 with an inlet opening 208 being 1 mm or less, the risk of water ingress may be eliminated or at least considerably reduced. The inlet opening 208 may have a substantially circular shape. The inlet opening 208 may be expandable from a closed configuration to an open configuration by deformation of the support part.

A size of the outlet opening 210 transverse to the longitudinal direction may be in the range of 1.0-3.0 mm. By providing the path 206 with an outlet opening 210 being in the range of 1.0-3.0 mm, the pressure along the path 206 may be reduce. The outlet opening 210 may have a substantially circular shape.

As the outlet opening 210 may be larger than the inlet opening 208, the cross-sectional size (the diameter) may taper down from the inlet opening 208 towards the outlet opening 210. In one embodiment, the cross-sectional size may taper down uniformly along the length of the path 206. In an alternative embodiment, as illustrated in Fig.2, the cross-sectional size of the path 206, which may be substantially circular, may be substantially uniform along the longitudinal direction of the insert part 202. The cross-sectional size may taper down from the inlet opening 208 only in the support part 204 of the sealing valve 200; i.e., along a part of the length of the path 206. A cavity 232 may thereby be provided in the support part 204, where the cavity 232 is in communication with the part of the path 206 which extends in the insert part 202. The cross-sectional size of the path 206 may thus taper down along the longitudinal direction of the support part 204.

The cross-sectional size/the outer diameter of the support part 204 along the first surface part 220 may form the largest cross-sectional size of the support part 204, as the cross-sectional size may decrease towards the inlet opening 208. The cross-sectional size of the support part 204 along the first surface past may be in the range of 1.5-2.5 times the cross-sectional size of the insert part 202 at the distal end 212, or even larger. In one embodiment the cross-sectional size of the support part 204 along the first surface past may be approximately 8 mm, whereas the cross-sectional size of the insert part 202 at the distal end 212 may be approximately 4 mm. In an alternative embodiment, the cross-sectional size of the support part 204 along the first surface past may be approximately 30 mm, whereas the cross-sectional size of the insert part 202 at the distal end 212 may be approximately 8 mm.

To limit the risk of unintentional removal of the sealing valve during handling of the housing, the size of the support part 204 in the longitudinal direction, the height of the support part, may be kept low. As an example, may the size of the insert part 202 in the longitudinal direction be at least twice the size H of the support part 204 in the longitudinal direction L.

Figs. 3-6 illustrate a cross-sectional view of a light fixture 100 in the form of a moving head light fixture as also illustrated in Fig. 1. Each of the head 101, the yoke 102, and the base 103 comprises a housing 120 for an electronic element. The housing 120 of the head 101 comprises at least a light source 302, the housing 120 of the yoke 102 comprises at least two motors 300A, 300B, and the housing 120 of the base 103 comprises as least a controller 304 for controlling the light fixture 100. Two motors 300A, 300B are arranged for movement of the head 101, where the first motor 300A is arranged for tilting the head 101, whereas the second motor 300B is arranged for panning the head 101.

The housing 120 comprises a wall 122 separating an exterior space 306 outside the housing 120 and an inner space 308 inside the housing. The wall 122 comprises an opening 310 between the exterior space 306 and the inner space 308. The wall 122 forms an outer surface 312 towards the exterior space 306 and an opposite inner surface 314 towards the inner space 308.

The housing 120 further comprises an elastically deformable sealing valve 200 (for details see Fig 2) configured to be removably inserted in the opening 310 to close the opening. By elastically deformable should be understood, that the shape of at least a part of the sealing valve 200 may be deformed by manually applying a pressure on the sealing valve 200. The elasticity of the sealing valve 200 may allow the sealing valve 200 to return to its initial shape after removing the applied pressure. As the sealing valve in one embodiment may be formed by a plurality of elements which are subsequently assembled to form the sealing valve, some part may not be deformable.

In the illustrated embodiment, the opening 310 is substantially circular. A cross-sectional shape of the groove 224 (see Fig. 2) transverse to the longitudinal direction L is also substantially circular to match the shape of the opening 310.

The housing 120 may comprise a plurality of walls, where at least one of these walls may be the wall comprising the opening 310. The wall may comprise more than one opening 310.

The wall may be substantially plane or substantially convex towards the exterior space 306 to thereby reduce the risk of water being trapped around the opening 310. The wall 120 may comprise another section which is not substantially plane or is not substantially convex towards the exterior space 306. However, the opening 310 in which the sealing valve 200 is inserted should preferably not arranged in such a section, as this would increase the risk of water ingress into the inner space 308 of housing 120 via the sealing valve 200.

To allow rotational movement of the head 101 relative to the yoke 102, the head 101 is suspended at two bearings 316A arranged at the yoke 102. The head 101 can be rotated around a substantially horizontal rotation axis extending through the bearings 316A by use of the motor 300A to tilt the head 101. To allow rotational movement of the head 101 and the yoke 102 relative to the base 103, the yoke 102 is suspended at a bearing 316B arranged at the base 103. The head 101 and the yoke 102 can be rotated around a substantially vertical rotation axis extending through the bearing 316B by use of the motor 300B.

The inner space 308 of head 101 may be in fluid communication with the inner space 308 of the yoke 102 allow air to move from the head 101 to the yoke 102 and to allow air to move in the opposite direction. By moving air form one inner space 308 to another inner space 308 cooling of the warmer inner space may be achieved. Air movement may be assisted by use of a fan (not shown) arranged in one of the inner spaces 308. In the illustrated embodiment, an air path 318 for fluid communication is arranged at one of the bearings 316A.

An external computer (not shown) may be in communication with a controller 304 integrated in the base 103. The controller 304 may be arranged to control the light source 302, to control a framing system, a colour system, zoom, focus, etc. (not shown) arranged to shape the light beam 110, to control movement the head 101, to control movement of the yoke 102.

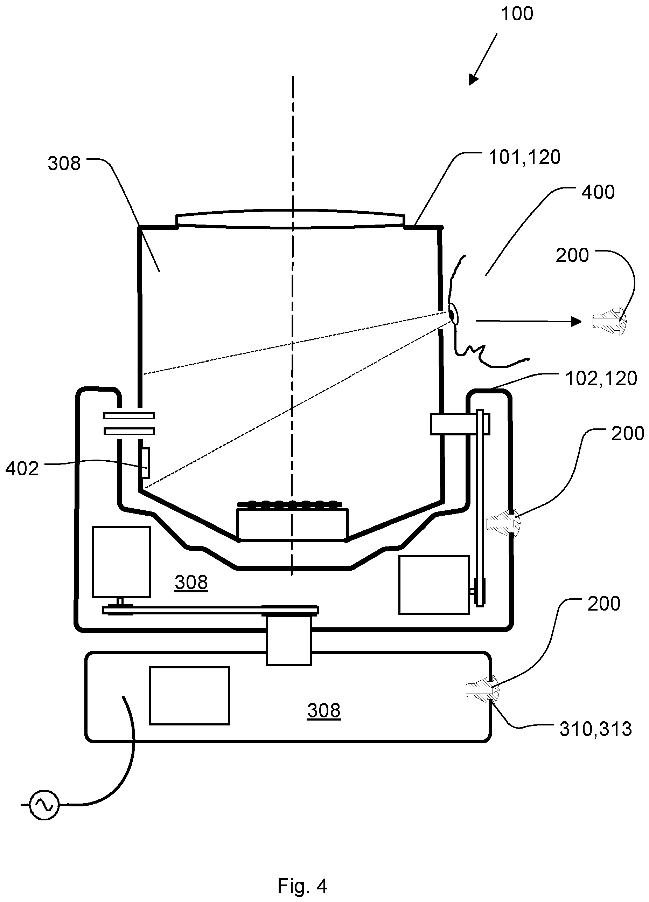

In Fig. 4, the sealing valve 200 which in Fig. 3 closes the opening 310 in the head 101 has been removed to allow for visual inspection of the inner space 308 illustrated by the person 400. The diameter of the opening 310 may be in the range of 5-20 mm. To allow a secure fit of the sealing valve 200 with the opening 310, when the sealing valve 200 is inserted into the opening, the outer diameter of the sealing valve 200 in the groove 224 may be substantially equal to the diameter of opening 310.

An indication sticker 402 could be arranged at the inner surface 314 of the head 101. The indication sticker 402 may be configured to change colour, if wetted. In case of water ingress into the inner space 308, the colour changes. If may be possible to identify such a change by removing the sealing valve 200, and subsequently look into the inner space 308 and check the colour of the indication sticker 402.

Traditionally, waterproof of a housing 120 may be tested by spraying water over the housing 120, such as over the light fixture 100. Subsequently, the housing 120 may be opened to check the inner space. After such a check, the housing 120 may be assembled again. However, there is a risk, that the housing 120 is not correctly assembled, whereby it may not be waterproof after the test is carried out. By providing the housing 120 with an opening 310 and a sealing valve 200, the test may be carried out without opening the housing 120, as the visual test of the indication sticker 402 may be performed without opening the housing 120.

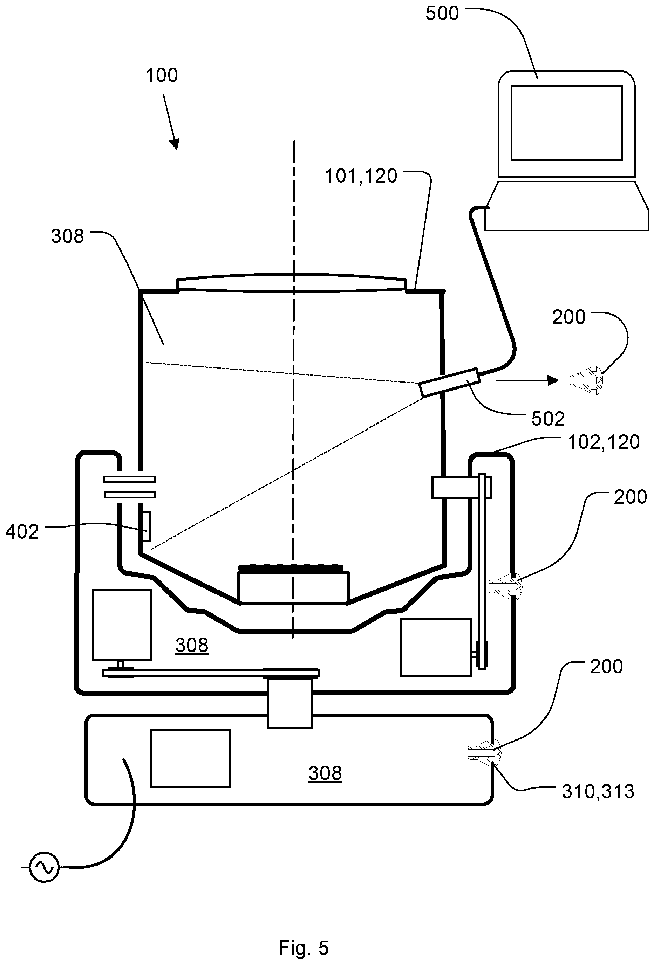

In Fig. 5, the sealing valve 200 which in Fig. 3 closes the opening 310 in the head 101 has been removed to allow for inspection of the inner space 308 by use of an external monitoring device 500 (e.g., a pc or a smart phone) and a camera 502. The camera 502 comprises a light source (not shown) to enable lighting of the inner space 308 by the light beam 504.

The camera 502 and the external computer may be used to investigate the inner space 308 of the housing 120. Investigation may be carried out not only in the inner space 308 of the head 101, but also in the yoke 102, and in the base 103. The investigation may as an example be used to check whether the housing 120 is waterproof or not by checking the indication sticker 402.

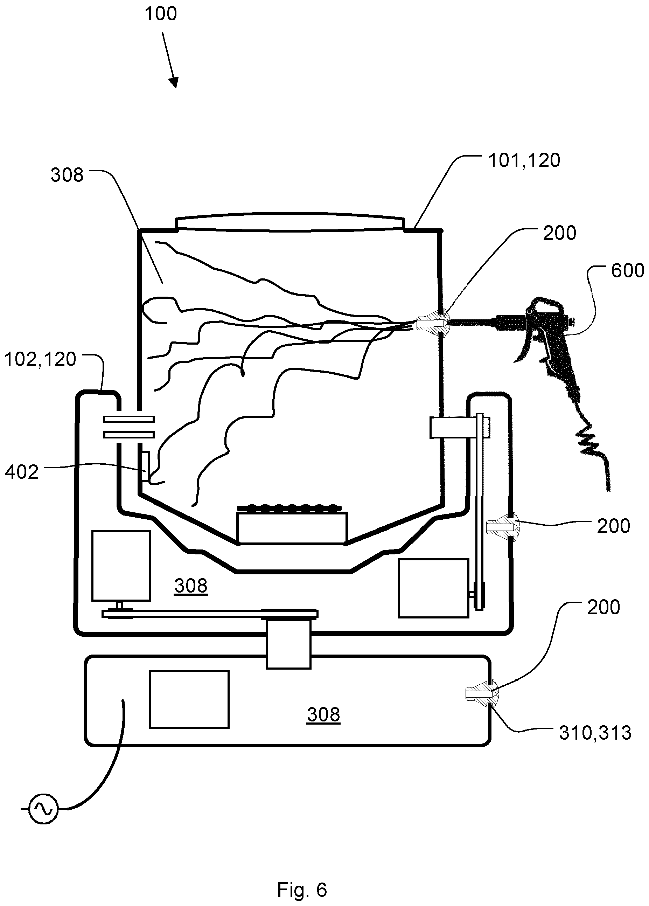

In Fig. 6, none of the sealing valves 200 have been removed. Instead, an air gun 600 is arranged at the sealing valve 200 at the head 101. The air gun 600 may be used to provide compressed air to the inner space 308 via the sealing valve 200, e.g., to clean or dry elements inside the housing 120 without opening the housing 120 which may be particularly relevant for housings to be used outside, such as ingress protected equipment (e.g., protection class IP44).

Air may pass the path 206 of sealing valve 200 by entering via the inlet opening 208 and entering the inner space 308 via the outlet opening 210. The compressed air may result in an overpressure in the inner space 308 which may press out dust, water droplets from condensation, and moist from the inner space 308 via vents, openings around joints, and specific ventilation openings (not shown) that does not allow water ingress in the housing.

The following numbered embodiments are provided:
Embodiment 1. A housing for an electronic element, the housing comprising:
   - a wall separating an exterior space outside the housing and an inner space inside the housing, the wall forming an outer surface towards the exterior space and an opposite inner surface towards the inner space and comprising an opening between the exterior space and the inner space, and
   - an elastically deformable sealing valve configured to be removably inserted in the opening to close the opening,

   wherein the sealing valve comprises an insert part for insertion into the opening and a support part for arrangement against the outer surface of the wall, the sealing valve forming a path from an inlet opening to an outlet opening, the path extending in a longitudinal direction, the inlet opening being formed in the support part and the outlet opening being formed in the insert part, and
   wherein the support part comprises a first surface part for arrangement against the outer surface of the wall, and wherein the insert part comprises a second surface part for arrangement against the inner surface of the wall, the first and second surface parts forming a groove extending circumferentially along an outer surface of the sealing valve transverse to the longitudinal direction, an edge portion of the wall being arranged in the groove, when the sealing valve is inserting in the opening.
Embodiment 2. The housing according to Embodiment 1, wherein the opening is substantially circular, and wherein a cross-sectional shape of the groove substantially matches a shape of the opening.
Embodiment 3. The housing according to any of the preceding Embodiments, wherein the wall is substantially plane or substantially convex towards the exterior space.
Embodiment 4. The housing according to any of the preceding Embodiments, wherein the support part has a height being defined as a dimension in the longitudinal direction, the height being lower along an outer circumference of the support part than at the inlet opening.
Embodiment 5. The housing according to Embodiment 4, wherein the height tapers down from the inlet opening towards the outer circumference.
Embodiment 6. The housing according to Embodiment 4 or 5, wherein an upper surface of the support part forms a substantially convex surface facing away from the wall. Embodiment 7. The housing according to any of Embodiments 4-6, wherein the height along the outer circumference is less than 2 mm.
Embodiment 8. The housing according to any of Embodiments 4-7, wherein the height along the outer circumference is 1/5 or less than a distance between the first and second surface parts.
Embodiment 9. The housing according to any of the preceding Embodiments, wherein an outer cross-sectional size of the insert part transverse to the longitudinal direction is larger at the second surface part than at an opposite distal end of the insert part.
Embodiment 10. The housing according to any of the preceding Embodiments, wherein a size of the inlet opening transverse to the longitudinal direction is 1 mm or less.
Embodiment 11. The housing according to any of the preceding Embodiments, wherein the inlet opening is expandable from a closed configuration to an open configuration by deformation of the support part.
Embodiment 12. The housing according to any of the preceding Embodiments, wherein a size of the outlet opening transverse to the longitudinal direction is in the range of 1.0-3.0 mm.
Embodiment 13. The housing according to any of the preceding Embodiments, wherein a cross-sectional size of the path is substantially uniform along the longitudinal direction of the insert part.
Embodiment 14. The housing according to any of the preceding Embodiments, wherein a cross-sectional size of the path tapers down along the longitudinal direction of the support part.
Embodiment 15. The housing according to any of the preceding Embodiments, wherein a cross-sectional size of the support part along the first surface past is in the range of 1.5-2.5 times a cross-sectional size of the insert part at the distal end.
Embodiment 16. The housing according to any of the preceding Embodiments, wherein a size of the insert part in the longitudinal direction is at least twice a size of the support part in the longitudinal direction.
Embodiment 17. The housing according to any of the preceding Embodiments, wherein the sealing valve is formed by a material being hydrophobic.
Embodiment 18. The housing according to any of the preceding Embodiments, wherein the housing forms part of a light fixture.
Embodiment 19. A method of manufacturing a sealing valve for a housing according to any of the preceding claims, the method comprising the steps of:
   - providing a mould and an ejector punch,
   - injecting a valve material into the mould to form the sealing valve,
   - setting the sealing valve, and
   - removing the sealing valve from the mould by use of the ejector punch.
Embodiment 20. The method according to Embodiment 19, wherein the ejector punch comprises a needle element, and wherein the step of removing the sealing valve from the mould comprises a step of providing the inlet opening by penetrating the support part by the needle element.

## Claims

1. A housing (120) for an electronic element, the housing comprising:
- a wall (122) separating an exterior space outside the housing and an inner space inside the housing, the wall forming an outer surface towards the exterior space and an opposite inner surface towards the inner space and comprising an opening (310) between the exterior space and the inner space, and
- an elastically deformable sealing valve (200) configured to be removably inserted in the opening to close the opening,
wherein the sealing valve comprises an insert part (202) for insertion into the opening and a support part (204) for arrangement against the outer surface of the wall, the sealing valve forming a path from an inlet opening (208) to an outlet opening (210), the path extending in a longitudinal direction, the inlet opening (208) being formed in the support part and the outlet opening being formed in the insert part, and
wherein the support part (204) comprises a first surface part (220) for arrangement against the outer surface of the wall, and wherein the insert part comprises a second surface part (222) for arrangement against the inner surface of the wall, the first and second surface parts forming a groove extending circumferentially along an outer surface of the sealing valve transverse to the longitudinal direction, an edge portion of the wall being arranged in the groove, when the sealing valve is inserting in the opening.

2. The housing according to claim 1, wherein the opening is substantially circular, and wherein a cross-sectional shape of the groove substantially matches a shape of the opening.

3. The housing according to any of the preceding claims, wherein the wall is substantially plane or substantially convex towards the exterior space.

4. The housing according to any of the preceding claims, wherein the support part (204) has a height being defined as a dimension in the longitudinal direction, the height being lower along an outer circumference of the support part than at the inlet opening.

5. The housing according to claim 4, wherein an upper surface of the support part (204) forms a substantially convex surface facing away from the wall.

6. The housing according to any of claim 4-5, wherein the height along the outer circumference is less than 2 mm.

7. The housing according to any of the preceding claims, wherein an outer cross-sectional size of the insert part (202) transverse to the longitudinal direction is larger at the second surface part than at an opposite distal end of the insert part.

8. The housing according to any of the preceding claims, wherein a size of the inlet opening transverse to the longitudinal direction is 1 mm or less.

9. The housing according to any of the preceding claims, wherein the inlet opening is expandable from a closed configuration to an open configuration by deformation of the support part.

10. The housing according to any of the preceding claims, wherein a size of the outlet opening transverse to the longitudinal direction is in the range of 1.0-3.0 mm.

11. The housing according to any of the preceding claims, wherein a cross-sectional size of the path is substantially uniform along the longitudinal direction of the insert part.

12. The housing according to any of the preceding claims, wherein a cross-sectional size of the path tapers down along the longitudinal direction of the support part.

13. The housing according to any of the preceding claims, wherein the housing forms part of a light fixture.

14. A method of manufacturing a sealing valve for a housing according to any of the preceding claims, the method comprising the steps of:
- providing a mould and an ejector punch,
- injecting a valve material into the mould to form the sealing valve,
- setting the sealing valve, and
- removing the sealing valve from the mould by use of the ejector punch.

15. The method according to claim 14, wherein the ejector punch comprises a needle element, and wherein the step of removing the sealing valve from the mould comprises a step of providing the inlet opening by penetrating the support part by the needle element.
